# EUROPÄISCHE PATENTSCHRIFT

(11) **EP 1 047 523 B1**
(45) Veröffentlichungstag und Bekanntmachung des Hinweises auf die Patenterteilung: **09.01.2002**
(21) Anmeldenummer: 99927895.5
(22) Anmeldetag: 07.06.1999
(51) Int. Cl.: B23K 35/00, H01L 23/495, B32B 15/01

(54) **VERFAHREN ZUR HERSTELLUNG EINES BLEIFREIEN SUBSTRATES**
METHOD FOR PRODUCING A LEAD-FREE SUBSTRATE
PROCEDE DE PRODUCTION D'UN SUBSTRAT EXEMPT DE PLOMB

(30) Priorität: 10.06.1998 DE 19825805; 03.11.1998 DE 19850526
(43) Veröffentlichungstag der Anmeldung: 02.11.2000
(73) Patentinhaber: W.C. Heraeus GmbH, D-63450 Hanau (DE)
(72) Erfinder: FÖRDERER, Heinz, D-63538 Grosskrotzenburg (DE); FREY, Thomas, D-63456 Hanau (DE); HERKLOTZ, Günter, D-63486 Bruchköbel (DE)
(74) Vertreter: Kühn, Hans-Christian
(86) Internationale Anmeldenummer: EP9903910
(87) Internationale Veröffentlichungsnummer: WO9964198

(56) Entgegenhaltungen:
- DE-A- 4 414 729
- US-A- 5 360 991
- US-A- 5 436 082

## Beschreibung

Die Erfindung betrifft ein Verfahren zur Herstellung eines bleifreien Substrates mit einem Grundkörper aus Kupfer oder einer Kupferlegierung, einer auf mindestens einem Teil des Grundkörpers aufgebrachten Lötschicht aus Metallen der Gruppe Gold, Goldlegierung, Silber, Silberlegierung, Palladium und Palladiumlegierung und einer einzigen zwischen dem Grundkörper und der Lötschicht angeordneten Zwischenschicht aus Nickel oder Nickellegierung, wobei die Lötschicht aus mindestens zwei Einzelschichten unterschiedlichen Materials gebildet ist und die Zwischenschicht und die Einzelschichten galvanisch abgeschieden sind.

In der Löttechnik werden allgemein Blei enthaltende Lote oder Lötschichten verwendet. Um das Blei mit seiner hohen Toxizität vermeiden zu können, sind bleifreie, lötbare Schichten mit guter Haftfestigkeit und Oxidationsbeständigkeit erforderlich, die eine ähnlich hohe Benetzbarkeit aufweisen wie beispielsweise herkömmliche Zinn-Blei-Lötschichten.

Lötschichten dieser Art sind aus der DE 44 14 729 C2 bekannt. Ein Basisstreifen aus Kupfer oder Kupferlegierung wird hier mit einer Zwischenschicht aus Nickel oder Nickellegierung beschichtet und darauf eine Schutzschicht in Dünnschichttechnik aufgebracht, die den Basisstreifen vor oxidativem Angriff schützt. Der Werkstoff wird zur Herstellung eines Leiterrahmens für Halbleiter-Bauelemente verwendet, wobei eine Schutzschicht mit einer Schichtdicke im Bereich von 1nm bis 50nm verwendet wird. Diese aufgedampfte, dünne Schutzschicht gewährleistet einen guten Oxidationsschutz des Basisstreifens bei ausreichender mechanischer Festigkeit einer später zwischen der Schutzschicht und einem Bauelement oder einer Platine herzustellenden Draht- oder Lötverbindung. Die Herstellung einer Schutzschicht in Dünnschichttechnik ist apparativ sehr aufwendig. So sind Sputter- oder Aufdampfanlagen teuer, wartungsintensiv und generell zur Ausführung von Vakuumprozessen vorgesehen, die in einer Reinraum-Peripherie stattfinden müssen.

Eine galvanisch aufgebrachte Schutzschicht aus Gold, die allerdings eine Dicke von mehreren µm aufweisen muß, um die Funktion einer "Schutzschicht" erfüllen zu können, wird als eine weitere, teuere Möglichkeit genannt, bei der die mechanische Festigkeit ebenfalls gewährleistet ist. Jedoch wird eine in Dünnschichttechnik hergestellte Schutzschicht für die Zuverlässigkeit als generell wirksamer eingestuft als eine galvanisch abgeschiedene Schicht.

Versuche bestätigten die in der DE 44 14 729 C2 aufgezeigten Nachteile galvanisch hergestellter Schutzschichten ( siehe Tabelle 1). Die Bestimmung der Benetzungsgeschwindigkeiten für frische und an Luft bei einer Temperatur von 155°C über einen Zeitraum von 16h (IEC 68-2-2; DIN EN 60068-2-2 ) ausgelagerte bleifreie Substrate wurde mit Hilfe einer Lötwaage vorgenommen. Eine Lötwaage ist mit einer ausreichend empfindlichen Kraftmeßeinrichtung ausgestattet, um die Grenzflächenkräfte zwischen einem geschmolzenen Lot und dem zu verlötenden Prüfling zu messen.

Entscheidend für den Lötvorgang sind die Qualität und Geschwindigkeit, mit der ein zu verlötender Prüfling von einem flüssigen Lot unter gleichen Versuchsbedingungen benetzt wird. Dazu wird der Prüfling teilweise in das flüssige Lot eingetaucht und die Kräfte, die auf den Prüfling aufgrund der Reaktion mit der Flüssigkeit einwirken, werden gemessen. Die resultierende Kraft aus den Vertikalkräften von Auftrieb und Benetzungskraft, die auf den eingetauchten Prüfling über eine bestimmte Zeit einwirkt, wird über einen Meßwandler gemessen und aufgezeichnet. Für die Auswertung relevant ist jeweils der Zeitpunkt, an dem die Benetzungskraft gleich groß der entgegengerichteten Auftriebskraft ist; daraus resultiert, daß die auf den Prüfling einwirkende resultierende Kraft gleich null ist. Die Zeitspanne bis zum Erreichen dieses Zustandes stellt ein direktes Maß für die Benetzungsgeschwindigkeit der jeweiligen Probe dar.

Die Meßwerte in Tabelle 1 wurden in einem Lotbad bei folgenden Parametern aufgenommen:
Temperatur: 240°C
Eintauchgeschwindigkeit: 5mm/s
Eintauchtiefe: 5mm
Flußmittel: FSW-31 (600g Rein-Kollophonium in 1I Isopropylalkohol) nicht aktivierend
Meßdauer: 5 s

**Tabelle 1**

| Schichtsystem | Benetzungs-Zeit (s) vor Auslagerung | Benetzungs-Zeit (s) nach Auslagerung |
|---|---|---|
| 5µm Sn/Pb 60/40 (Vergleich) | 0,45 | 0,50 |
| 2µm Ni + 0,1µm bis 0,2µm Pd | 1,50 | 2,05 |
| 2µm Ni/P + 0,1µm bis 0,2µm Pd | 1,50 | 1,65 |
| 2µm Ni + 5µm Ag | 0,90 | 1,00 |
| 2µm Ni + 0,2µm Pd/Ni | 3,95 | > 5,00 |
| 2µm Ni + 0,5µm Au (fein) | 1,00 | 1,00 |
| 2µm Ni + 0,5µm Au/Co (Hartgoid) | 1,15 | 4,55 |

Daraus stellt sich das Problem, ein kostengünstigeres Verfahren für die Herstellung eines bleifreien Substrates bereitzustellen, bei dem nach Auslagerung gemäß DIN EN 60068-2-2 eine Benetzungs-Zeit kleiner als 1 Sekunde erreicht wird.

Das Problem wird überraschend dadurch gelöst, daß die Lötschicht aus mindestens zwei Einzelschichten unterschiedlichen Metalls gebildet wird und die Zwischenschicht und die Einzelschichten der Lötschicht galvanisch abgeschieden werden. Eine ausreichend hohe mechanische Festigkeit der Draht- oder Lötverbindung zwischen der Lötschicht und einem Bauelement oder einer Platine ist langzeitstabil gewährleistet.
Dabei hat es sich als vorteilhaft erwiesen, wenn die Zwischenschicht mit einer Schichtdicke im Bereich von 0,1µm bis 10µm hergestellt wird. Dazu kann ein handelsübliches Nickel - Bad auf Sulfamat-Basis in Verbindung mit einer Stromdichte im Bereich von 0,5 A/dm² bis 10 A/dm² verwendet werden.

Eine effektive Lötschicht wird aus einer ersten und einer zweiten Einzelschicht hergestellt, wobei die auf der Zwischenschicht abgeschiedene erste Einzelschicht eine Schichtdicke im Bereich von 0,01µm bis 5µm und die zweite Einzelschicht eine Schichtdicke im Bereich von 0,01µm bis 10µm aufweisen sollte. Idealerweise wird die erste Einzelschicht aber mit einer Schichtdicke im Bereich von 0,1µm bis 1,0µm und die zweite Einzelschicht mit einer Schichtdicke im Bereich von 0,3µm bis 2,5µm hergestellt. Die Lötschicht kann aber auch aus mehr als zwei oder drei Einzelschichten gebildet werden.

Eine Lötschicht, die mit einer ersten Einzelschicht aus Palladium oder Palladiumlegierung und einer zweiten Einzelschicht aus Silber oder Silberlegierung hergestellt wird, hat sich bewährt. Vorteilhaft ist es aber auch, wenn eine der beiden Einzelschichten aus Gold oder Goldlegierung hergestellt ist. Hier kann die erste Einzelschicht aus Gold oder Goldlegierung und die zweite Einzelschicht aus Silber oder Silberlegierung hergestellt werden oder aber die zweite Einzelschicht aus Gold oder Goldlegierung und die erste Einzelschicht aus Silber oder Silberlegierung hergestellt werden. Für die Herstellung von Einzelschichten aus Palladium oder Palladiumlegierungen können ammoniakalische Bäder, für die Herstellung von Einzelschichten aus Gold oder Goldlegierung cyanidische Bäder jeweils in Verbindung mit einer Stromdichte im Bereich von 0,1 A/dm² bis 5 A/dm² verwendet werden.

Hohe Benetzungsgeschwindigkeiten nach Auslagerung werden zudem erreicht, wenn die Lötschicht aus einer ersten, einer zweiten und einer dritten Einzelschicht hergestellt wird und die auf der Zwischenschicht abgeschiedene erste Einzelschicht sowie die zweite Einzelschicht jeweils eine Schichtdicke im Bereich von 0,01µm bis 5µm aufweisen und die dritte Einzelschicht eine Schichtdicke im Bereich von 0,01µm bis 10µm aufweist. Idealerweise weist die erste Einzelschicht eine Schichtdicke im Bereich von 0,1µm bis 1µm auf und weisen die zweite Einzelschicht und die dritte Einzelschicht jeweils eine Schichtdicke im Bereich von 0,3µm bis 2,5µm auf.

Als günstig hat sich eine erste Einzelschicht aus Palladium oder Palladiumlegierung und eine zweite Einzelschicht aus Silber oder Silberlegierung verbunden mit einer dritten Einzelschicht aus Gold oder Goldlegierung erwiesen. Die Benetzungsgeschwindigkeit nach Auslagerung ist jedoch bei einer ersten Einzelschicht aus Palladium oder Palladiumlegierung und einer zweiten Einzelschicht aus Gold oder Goldlegierung verbunden mit einer dritten Einzelschicht aus Silber oder Silberlegierung noch höher.

Auf alle Lötschichten kann zusätzlich eine Reinzinnschicht aufgebracht werden.
Bildet eine Einzelschicht aus Silber oder einer Silberlegierung die oberste Einzelschicht, dann ist es von Vorteil, wenn diese mit einer Anlaufschutzschicht überzogen wird, die ein Anlaufen, das heißt Oxidieren des Silbers, verhindert. insbesondere ist die Silbersulfid - Bildung unerwünscht und wird beispielsweise durch Thiole wirksam verhindert.

So erreichen alle Substrate eine niedrige Benetzungszeit, die bei einigen Substraten nach der Auslagerung noch weiter verringert ist. Nach der Auslagerung werden für alle bleifreien Substrate Benetzungszeiten unterhalb einer Sekunde gemessen; teilweise wird dabei sogar der Vergleichswert für die Sb/Pb-Lötschichten von 0,5s unterschritten. In Tabelle 2 werden die bei folgenden Parametern erreichten Meßergebnisse dargestellt:
Temperatur: 240°C
Eintauchgeschwindigkeit: 5mm/s
Eintauchtiefe: 5mm
Flußmittel: FSW-31 (600 g Rein-Kollophonium in 1 I Isopropylalkohol) nicht aktivierend
Meßdauer: 5 s

**Tabelle 2**

| Schichtsystem | Benetzungs-Zeit (s) vor Auslagerung | Benetzungs-Zeit (s) nach Auslagerung |
|---|---|---|
| 5µm Sn/Pb 60/40 (Vergleich) | 0,45 | 0,50 |
| 2µm Ni + 0,1µm bis 0,2µm Pd + 0,5µm Ag | 0,70 | 0,75 |
| 2µm Ni + 0,1µm bis 0,2µm Pd + 2,0µm Ag | 0,60 | 0,65 |
| 2µm Ni + 0,5µm Pd + 0,5µm Ag | 0,55 | 0,70 |
| 2µm Ni + 0,5µm Pd + 1,0µm Ag | 0,65 | 0,75 |
| 2µm Ni + 0,5µm Pd + 2,0µm Ag | 0,65 | 0,80 |
| 2µm Ni+0,2µm Pd/Ni (80Gew.-% Pd, 20Gew.-% Ni)+0,5µm Ag | 0,50 | 0,45 |
| 2µm Ni+0,2µm Pd/Ni (80Gew.-% Pd, 20Gew.-% Ni)+2,0µm Ag | 0,50 | 0,40 |
| 2µm Ni+0,5µm Pd/Ni (80Gew.-% Pd, 20Gew.-% Ni)+0,5µm Ag | 0,45 | 0,40 |
| 2µm Ni+0,5µm Pd/Ni (80Gew.-% Pd, 20Gew.-% Ni)+2,0µm Ag | 0,45 | 0,45 |
| 2µm Ni+0,1µm bis 0,2µm Pd+2,0µm Ag (mit Anlaufschutz ) | 0,40 | 0,60 |
| 2µm Ni + 0,2µm Pd + 0,5µm Ag ( mit Anlaufschutz ) | 0,40 | 0,50 |
| 2µm Ni + 0,5µm Pd + 2,0µm Ag ( mit Anlaufschutz ) | 0,40 | 0,50 |
| 2µm Ni + 0,8µm Au (fein) + 0,5µm Ag | 0,40 | 0,45 |
| 2µm Ni + 0,2µm Au (fein) + 0,5µm Ag | 0,45 | 0,50 |
| 2µm Ni + 0,2µm Au/Co (Hartgold) + 0,5µm Ag | 0,45 | 0,50 |
| 2µm Ni + 0,2µm Au/Co (Hartgold) + 2,0µm Ag | 0,45 | 0,45 |
| 2µm Ni + 0,2µm Au (fein) + 2,0µm Ag | 0,45 | 0,50 |
| 2µm Ni + 0,5µm Ag + 0,5µm Au (fein) | 1,00 | 0,50 |
| 2µm Ni + 0,5µm Ag + 0,5µm Au/Co (Hartgold) | 1,30 | 0,55 |
| 2µm Ni + 0,5µm Ag + 0,2µm Au (fein) | 0,60 | 0,40 |
| 2µm Ni + 0,5µm Ag + 0,2µm Au/Co (Hartgold) | 0,80 | 0,50 |
| 2µm Ni + 0,2µm Pd + 0,5µm Ag + 0,5µm Au (fein) | 0,55 | 0,45 |
| 2µm Ni +0,2µm Pd + 0,5µm Ag + 0,5µm Au/Co (Hartgold) | 0,80 | 0,50 |
| 2µm Ni + 0,2µm Pd + 0,2µm Au (fein) + 0,5µm Ag | 0,50 | 0,45 |
| 2µm Ni + 0,2µm Pd + 0,2µm Au/Co (Hartgold)+ 0,5µm Ag | 0,45 | 0,40 |

Folgende Beispiele sollen das erfindungsgemäße Verfahren für die Herstellung der bleifreien Substrate näher erläutern:

### Beispiel 1: Verfahren zu Herstellung eines bleifreien Substrates mit einer Lötschicht aus Pd/Ni und Ag

### Beispiel 2: Verfahren zu Herstellung eines bleifreien Substrates mit einer Lötschicht aus Pd, Au/Co (Hartgold) und Ag

### Bps. 1:

- Reinigen, Entfetten und Spülen eines Grundkörpers aus Kupfer
- Beschichtung des Kupfers mit 2,0µm Nickel in einem handelsüblichen, galvanischen Ni - Bad auf Sulfamat-Basis bei einer Stromdichte von 2,5 A/dm² und anschließendes Spülen
- Beschichtung der Nickel - Schicht mit 0,2µm Pd/Ni in einem ammoniakalischen Pd/Ni - Bad bei einer Stromdichte von 1,0 A/dm² und anschließendes Spülen
- Beschichtung der Pd/Ni - Schicht mit 2,0µm Ag in einem cyanidischen Ag - Bad bei einer Stromdichte von 1,0 A/dm² und anschließendes Spülen
- Trocknen
- Auslagerung an Luft bei einer Temperatur 155°C über einen Zeitraum von 16h

### Bsp. 2:

- Reinigen, Entfetten und Spülen eines Grundkörpers aus Kupfer
- Beschichtung des Kupfers mit 2,0µm Nickel in einem handelsüblichen, galvanischen Ni - Bad auf Sulfamat-Basis bei einer Stromdichte von 2,5 A/dm² und anschließendes Spülen
- Beschichtung der Nickel - Schicht mit 0,2µm Pd in einem ammoniakalischen Pd - Bad bei einer Stromdichte von 1,0 A/dm² und anschließendes Spülen
- Beschichtung der Pd - Schicht mit 0,2µm Au/Co (Hartgold) in einem cyanidischen Au/Co - Bad bei einer Stromdichte von 1,0 A/dm² und anschließendes Spülen
- Beschichtung der Au/Co - Schicht mit 0,5µm Ag in einem cyanidischen Ag - Bad bei einer Stromdichte von 1,0 A/dm² und anschließendes Spülen
- Trocknen
- Auslagerung an Luft bei einer Temperatur 155°C über einen Zeitraum von 16h

## Patentansprüche

1. Verfahren zur Herstellung eines bleifreien Substrates mit einem Grundkörper aus Kupfer oder einer Kupferlegierung, einer auf mindestens einem Teil des Grundkörpers aufgebrachten Lötschicht aus Metallen aus der Gruppe Gold, Goldlegierung, Silber, Silberlegierung, Palladium und Palladiumlegierung und einer einzigen zwischen dem Grundkörper und dieser Lötschicht angeordneten Zwischenschicht aus Nickel oder Nickellegierung, wobei die Lötschicht aus mindestens zwei Einzelschichten unterschiedlichen Metalls gebildet ist und die Zwischenschicht und die Einzelschichten galvanisch abgeschieden sind, **dadurch gekennzeichnet, dass** eine Einzelschicht der beiden obersten Einzelschichten aus Silber oder Silberlegierung gebildet wird und dass die andere der beiden obersten Einzelschichten aus Gold oder Goldlegierung gebildet wird, wobei die oberste Einzelschicht mit einer Schichtdicke im Bereich von 0,3µm bis 2,5µm gebildet wird.

2. Verfahren zur Herstellung eines bleifreien Substrates nach Anspruch 1, **dadurch gekennzeichnet, dass** die Lötschicht aus einer ersten und einer zweiten Einzelschicht hergestellt wird, die gleichzeitig die beiden obersten Einzelschichten sind, und die auf der Zwischenschicht abgeschiedene erste Einzelschicht eine Schichtdicke im Bereich von 0,01µm bis 5µm aufweist.

3. Verfahren zur Herstellung eines bleifreien Substrates nach Anspruch 2, **dadurch gekennzeichnet, dass** die erste Einzelschicht eine Schichtdicke im Bereich von 0,1µm bis 1µm aufweist.

4. Verfahren zur Herstellung eines bleifreien Substrates nach einem der Ansprüche 2 bis 3, **dadurch gekennzeichnet, dass** die erste Einzelschicht aus Gold oder Goldlegierung und die zweite Einzelschicht aus Silber oder Silberlegierung hergestellt wird.

5. Verfahren zur Herstellung eines bleifreien Substrates nach einem der Ansprüche 2 bis 3, **dadurch gekennzeichnet, dass** die zweite Einzelschicht aus Gold oder Goldlegierung und die erste Einzelschicht aus Silber oder Silberlegierung hergestellt wird.

6. Verfahren zur Herstellung eines bleifreien Substrates nach Anspruch 1, **dadurch gekennzeichnet, dass** die Lötschicht aus einer ersten, einer zweiten und einer dritten Einzelschicht hergestellt wird, wobei die zweite und dritte Einzelschicht gleichzeitig die beiden obersten Einzelschichten sind, und die auf der Zwischenschicht abgeschiedene erste Einzelschicht sowie die zweite Einzelschicht jeweils eine Schichtdicke im Bereich von 0,01µm bis 5µm aufweisen.

7. Verfahren zur Herstellung eines bleifreien Substrates nach Anspruch 6, **dadurch gekennzeichnet, dass** die erste Einzelschicht eine Schichtdicke im Bereich von 0,1µm bis 1µm aufweist und die zweite Einzelschicht eine Schichtdicke im Bereich von 0,3µm bis 2,5µm aufweist.

8. Verfahren zur Herstellung eines bleifreien Substrates nach einem der Ansprüche 6 bis 7, **dadurch gekennzeichnet, dass** die erste Einzelschicht aus Palladium oder Palladiumlegierung hergestellt wird und die zweite Einzelschicht aus Silber oder Silberlegierung hergestellt wird und die dritte Einzelschicht aus Gold oder Goldlegierung hergestellt wird.

9. Verfahren zur Herstellung eines bleifreien Substrates nach einem der Ansprüche 6 bis 7, **dadurch gekennzeichnet, dass** die erste Einzelschicht aus Palladium oder Palladiumlegierung hergestellt wird und die zweite Einzelschicht aus Gold oder Goldlegierung hergestellt wird und die dritte Einzelschicht aus Silber oder Silberlegierung hergestellt wird.

10. Verfahren zur Herstellung eines bleifreien Substrates nach einem der Ansprüche 4 oder 9, **dadurch gekennzeichnet, dass** auf die zweite oder dritte Einzelschicht aus Silber oder Silberlegierung eine Anlaufschutzschicht aufgebracht wird.

## Claims

1. Process for the production of a lead-free substrate comprising a base element of copper or of a copper alloy, a solder layer applied to at least a part of the base element and comprising metals from the group consisting of gold, gold alloy, silver, silver alloy, palladium and palladium alloy and a single intermediate layer arranged between the base element and the solder layer and comprising nickel or nickel alloy, the solder layer being formed from at least two individual layers of different metals and the intermediate layer and the individual layers being applied by electrodeposition, **characterized in that** one individual layer of the two uppermost individual layers is formed from silver or silver alloy and that the other individual layer of the two uppermost individual layers is formed from gold or gold alloy, the uppermost individual layer being formed with a layer thickness in the range of from 0.3 µm to 2.5 µm.

2. Process for the production of a lead-free substrate according to Claim 1, **characterized in that** the solder layer is produced from a first and a second individual layer, which are simultaneously the two uppermost individual layers, and the first individual layer deposited on the intermediate layer has a layer thickness in the range of from 0.01 µm to 5 µm.

3. Process for the production of a lead-free substrate according to Claim 2, **characterized in that** the first individual layer has a layer thickness in the range of from 0.1 µm to 1 µm.

4. Process for the production of a lead-free substrate according to either of claims 2 and 3, **characterized in that** the first individual layer is produced from gold or gold alloy and the second individual layer from silver or silver alloy.

5. Process for the production of a lead-free substrate according to either of Claims 2 and 3, **characterized in that** the second individual layer is produced from gold or gold alloy and the first individual layer from silver or silver alloy.

6. Process for the production of a lead-free substrate according to Claim 1, **characterized in that** the solder layer is produced from a first, a second and a third individual layer, the second and third individual layers simultaneously being the two uppermost individual layers, and the first individual layer deposited on the intermediate layer, and the second individual layer, each have a layer thickness in the range of from 0.01 µm to 5 µm.

7. Process for the production of a lead-free substrate according to Claim 6, **characterized in that** the first individual layer has a layer thickness in the range of from 0.1 µm to 1 µm and the second individual layer has a layer thickness in the range of from 0.3 µm to 2.5 µm.

8. Process for the production of a lead-free substrate according to either of Claims 6 and 7, **characterized in that** the first individual layer is produced from palladium or palladium alloy and the second individual layer is produced from silver or silver alloy and the third individual layer is produced from gold or gold alloy.

9. Process for the production of a lead-free substrate according to either of Claims 6 and 7, **characterized in that** the first individual layer is produced from palladium or palladium alloy and the second individual layer is produced from gold or gold alloy and the third individual layer is produced from silver or silver alloy.

10. Process for the production of a lead-free substrate according to either of claims 4 and 9, **characterized in that** an antitarnish layer is applied to the second or third individual layer of silver or silver alloy.

## Revendications

1. Procédé pour produire un substrat exempt de plomb, avec un corps de base en cuivre ou en alliage de cuivre, une couche de brasage, déposée sur une partie au moins du corps de base, en métaux parmi le groupe comprenant or, alliage d'or, argent, alliage d'argent, palladium et alliage de palladium, et une seule couche intermédiaire en nickel ou en alliage de nickel agencée entre le corps de base et cette couche de brasage, la couche de brasage étant formée par au moins deux couches individuelles en métaux différents, et la couche intermédiaire et les couches individuelles étant déposées par voie galvanique, **caractérisé en ce qu'**une couche individuelle des deux couches individuelles supérieures est formée en argent ou en alliage d'argent, et **en ce que** l'autre couche des deux couches individuelles supérieures est formée en or ou en alliage d'or, la couche individuelle supérieure étant formée avec une épaisseur de l'ordre de 0,3 µm à 2,5 µm.

2. Procédé pour produire un substrat exemple de plomb selon la revendication 1, **caractérisé en ce que** la couche de brasage est réalisée par une première et par une seconde couche individuelle, qui sont simultanément les deux couches individuelles supérieures, et **en ce que** la première couche individuelle déposée sur la couche intermédiaire présente une épaisseur de l'ordre de 0,01 µm à 5 µm.

3. Procédé pour produire un substrat exemple de plomb selon la revendication 2, **caractérisé en ce que** la première couche individuelle présente une épaisseur de l'ordre de 0,1 µm à 1 µm.

4. Procédé pour produire un substrat exemple de plomb selon l'une ou l'autre des revendications 2 et 3, **caractérisé en ce que** la première couche individuelle est réalisée en or ou en alliage d'or et la seconde couche individuelle est réalisée en argent ou en alliage d'argent.

5. Procédé pour produire un substrat exemple de plomb selon l'une ou l'autre des revendications 2 et 3, **caractérisé en ce que** la seconde couche individuelle est réalisée en or ou en alliage d'or et la première couche individuelle est réalisée en argent ou en alliage d'argent.

6. Procédé pour produire un substrat exemple de plomb selon la revendication 1, **caractérisé en ce que** la couche de brasage est réalisée par une première, une seconde et une troisième couche individuelle, la seconde et la troisième couche individuelle étant simultanément les deux couches individuelles supérieures, et la première couche individuelle déposée sur la couche intermédiaire ainsi que la seconde couche individuelle présentent chacune une épaisseur de l'ordre de 0,01 µm à 5 µm.

7. Procédé pour produire un substrat exemple de plomb selon la revendication 6, **caractérisé en ce que** la première couche individuelle présente une épaisseur de l'ordre de 0,1 µm à 1 µm et la seconde couche individuelle présente une épaisseur de l'ordre de 0,3 µm à 2,5 µm.

8. Procédé pour produire un substrat exemple de plomb selon l'une ou l'autre des revendications 6 et 7, **caractérisé en ce que** la première couche individuelle est réalisée en palladium ou en alliage de palladium, et la seconde couche individuelle est réalisée en argent ou en alliage d'argent, et la troisième couche individuelle est réalisée en or ou en alliage d'or.

9. Procédé pour produire un substrat exemple de plomb selon l'une ou l'autre des revendications 6 et 7, **caractérisé en ce que** la première couche individuelle est réalisée en palladium ou en alliage de palladium, et la seconde couche individuelle est réalisée en or ou en alliage d'or, et la troisième couche individuelle est réalisée en argent ou en alliage d'argent.

10. Procédé pour produire un substrat exemple de plomb selon l'une ou l'autre des revendications 4 et 9, **caractérisé en ce que** sur la seconde ou sur la troisième couche individuelle en argent ou en alliage d'argent est déposée une couche de protection anti-condensation.
